# EUROPEAN PATENT SPECIFICATION

(11) **EP 0 349 107 B1**
(45) Date of publication and mention of the grant of the patent: **17.03.1999**
(21) Application number: 89304626.8
(22) Date of filing: 08.05.1989
(51) Int. Cl.: H01L 29/732, H01L 21/331, H01L 21/763, H01L 21/8222, H01L 21/60

(54) **Method of making a bipolar transistor integrated circuit**
Verfahren zur Herstellung einer integrierten Schaltung mit Bipolartransistoren
Méthode de fabrication d'un circuit intégré à transistors bipolaires

(30) Priority: 30.06.1988 JP 163804/88
(43) Date of publication of application: 03.01.1990
(73) Proprietor: Sony Corporation, Tokyo 141-0001 (JP)
(72) Inventor: Hozumi, Hiroki c/o Patent Division, Shinagawa-ku Tokyo 141 (JP); Nakamura, Minoru c/o Patent Division, Shinagawa-ku Tokyo 141 (JP); Miwa, Hiroyuki c/o Patent Division, Shinagawa-ku Tokyo 141 (JP); Kayanuma, Akio c/o Patent Division, Shinagawa-ku Tokyo 141 (JP)
(74) Representative: Cotter, Ivan John

(56) References cited:
- EP-A- 0 107 902
- EP-A- 0 170 250
- EP-A- 0 245 622
- GB-A- 2 148 593
- US-A- 4 688 069

## Description

This invention relates to methods of making bipolar transistor integrated circuits. Embodiments of the invention can produce extremely high speed transistors in integrated circuits.

There has recently been proposed a bipolar transistor integrated circuit produced by a trenching isolation process, which effects desired isolation of component elements by forming a deep ditch or trench of V or U-shaped cross-section, in an element isolating region. An example of such element isolating trenches is provided by US Patent No. 4 688 069. European Patent Application No. EP-A-0 107 902 discloses a method of fabricating isolation trenches wherein a silicon dioxide film is applied to the surface of a semiconductor body, a silicon nitride film is applied over the silicon dioxide film, and the silicon dioxide and silicon nitride films, and the semiconductor body, are selectively removed to form U-shaped grooves in the semiconductor body. UK Patent Application No. GB-A-2 148 593 discloses a similar method for forming isolation trenches in the manufacture of a bipolar-type semiconductor integrated circuit.

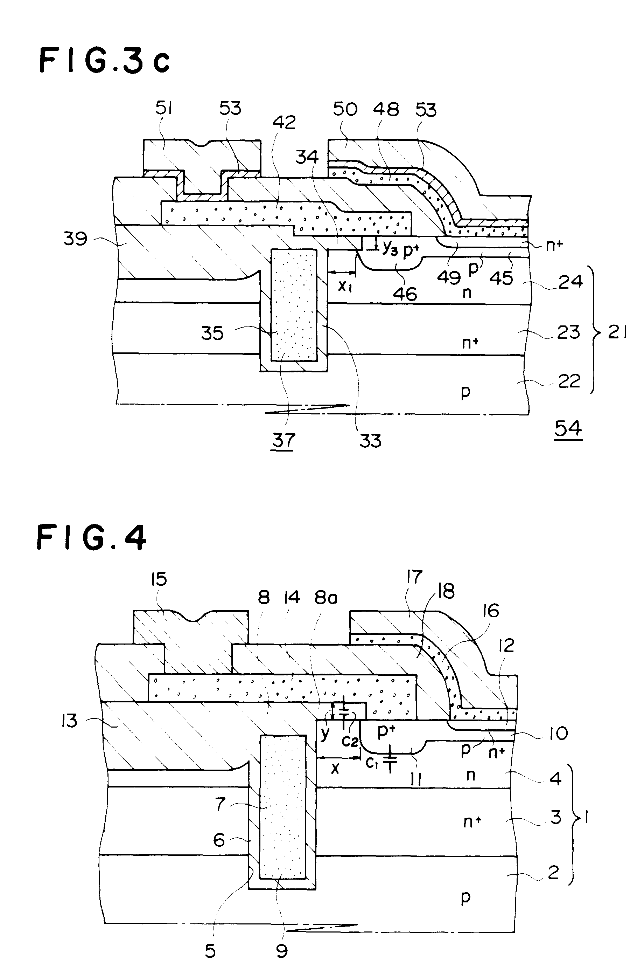

Figure 4 shows a portion of a previously proposed bipolar transistor integrated circuit made using a trenching isolation process. In this structure, a silicon semiconductor body 1 formed by epitaxially depositing, on a p-type silicon substrate 2 for example, an n-type semiconductor layer 3 to serve as a collector buried region, and a high-resistivity n-type semiconductor layer 4 to serve as a collector region. Subsequently an element isolating trench 5 is formed in the semiconductor body 1 and, after the inner surface of the trench 5 has been oxidized to form a silicon dioxide film 6, a polycrystalline silicon layer 7 and a silicon dioxide layer 8 are buried therein to form a trenched element isolating region 9.

There is also a p-type base region 10, a p⁺ base contact region 11, a n-type emitter region 12, and a field oxide layer 13 formed by selective oxidation (LOCOS).

The base contact region 11 is formed by diffusion of, for instance, boron from a polycrystalline silicon layer 14 doped with a p-type impurity such as boron, and the polycrystalline silicon layer 14 is used as a lead for a base electrode 15. The emitter region 12 is formed by diffusion of, for instance, arsenic from a polycrystalline silicon layer 16 doped with an n-type impurity such as arsenic, and an emitter electrode 17 is formed on the polycrystalline silicon layer 16. There is also a silicon dioxide layer 18. Although not shown, a collector electrode is formed through the collector buried region 3.

In the stage of forming the base contact region 11, first a silicon dioxide layer 8a on the body 1 including the isolating region 9 is patterned, then the boron-doped polycrystalline silicon layer 14 deposited thereon is patterned, and subsequently a heat treatment is effected. In this stage, the silicon dioxide layer 8a may be entirely removed. However, such technique also induces partial removal of the inner silicon dioxide layer 8 existing in the trench 5 consequently to cause a level difference. This level difference has a deleterious effect on the subsequent steps. For the purpose of overcoming this problem, the silicon dioxide layer 8a is provided to maintain satisfactory flatness.

In the bipolar transistor of Figure 4, it is necessary to reduce the capacitance C_{CB} between the collector and the base for achieving fast operation. This capacitance C_{CB} is determined principally by the sum of the p⁺-n junction capacitance C₁ in the base contact region 11 and the capacitance between the polycrystalline silicon layer 14 and the collector region 4 with the silicon dioxide layer 8a interposed, that is, the MIS capacitance C₂ under the lead for the base. (That is, C_{CB} = C₁ + C₂). And even if the p⁺-n junction capacitance C₁ is reduced in a self-alignment step, the contribution of the MIS capacitance C₂ is still not negligible.

Effective reduction of the MIS capacitance C₂ may be achieved by diminishing the space x between the base contact region 11 and the isolating region 9. However, it has been known that a dimensional tolerance of 0.2 to 0.3 µm is the limit with regard to the space x between the base contact region 11 and the isolating region 9. Furthermore, due to a level difference, the thickness y of the silicon dioxide layer 8a is restricted to 0.1 µm or so.

According to the present invention there is provided a method of making a bipolar transistor integrated circuit comprising a bipolar transistor having an active region and isolating trenches, the method comprising the steps of:
providing a semiconductor body having a surface and a semiconductor layer of a first conductivity type adjoining said surface;
oxidizing the surface of the body thereby forming a thin buffer layer;
forming thereon an oxidation resistant film and a silicon dioxide film;
forming windows extending through said silicon dioxide film, said oxidation resistant film and said buffer layer in portions where said isolating trenches are to be formed;
etching the semiconductor body through said windows while the silicon dioxide film, the oxidation resistant film and the buffer layer are used as masks, thereby forming isolating trenches having inner walls and upper edges;
removing said silicon dioxide film by etching, while portions of said buffer layer adjacent to said isolating trenches are also etched under the oxidation resistant film thereby forming undercut portions along the inner walls of said isolating trenches and the upper edges thereof;
thermally oxidizing the inner wall surfaces of said isolating trenches with said oxidation resistant film used as a mask, thereby forming insulator layers, the semiconductor body surface opposed to said undercut portions of the buffer layer being oxidized simultaneously during the thermal oxidation, thereby forming an insulator region buried in the surface portion of said semiconductor body adjacent to the upper edges of said isolating trenches;
removing said oxidation resistant film;
forming a silicon dioxide layer on the semiconductor body inclusive of said isolating trenches;
etching back said silicon dioxide layer, a thickness being left over said surface of the semiconductor body, said silicon dioxide layer being buried in said isolating trenches thereby forming isolating regions;
removing the portion of said silicon dioxide layer located on said active region of the bipolar transistor;
depositing a semiconductor conductive layer doped with an impurity of a second conductivity type on the entire surface and selectively etching said semiconductor conductive layer except for a portion covering said active region of the bipolar transistor;
forming a further silicon dioxide layer on the entire surface; selectively removing said semiconductor conductive layer and said further silicon dioxide layer by etching, whereby a window is defined within said active region where a base region is to be formed, said semiconductor conductive layer being left extending outside said window;
introducing an impurity of said second conductivity type through said window to form a base region, and diffusing said impurity of said second conductivity type from said semiconductor conductive layer into the periphery of the base region to form a base contact region;
forming a side wall of silicon dioxide on the inner surface of said window;
depositing a polycrystalline silicon layer doped with an impurity of said first conductivity type on the base region, and diffusing the impurity from said polycrystalline silicon layer, whereby an emitter region is formed in the base region;
forming an emitter electrode on said polycrystalline silicon layer and a base electrode on said semiconductor conductive layer.

In the embodiments of the invention a trenched isolating region is formed in a semiconductor body and a wiring layer extends on the isolating region and is connected to an impurity region on the semiconductor body. An insulator layer region is buried in the surface portion of the semiconductor body under the wiring layer and adjacent to the isolating region.

The insulator layer region buried in the surface portion of the semiconductor body adjacent to the isolating region can be made sufficiently thick consequently to diminish the parasitic capacitance between the wiring layer and the semiconductor body surface. In addition, because of the resultant dimensional reduction relative to the insulator layer region between the isolating region and the impurity region, it becomes possible further to decrease the parasitic capacitance between the wiring layer and the semiconductor body surface.

The invention will now be described by way of example with reference to the accompanying drawings, in which:
Figures 1A to 10 show steps in producing a semiconductor device according to an embodiment of the present invention;
Figure 2 is an enlarged sectional view of parts of the semiconductor device;
Figures 3A to 3C show other steps in producing the semiconductor device;
Figure 4 is a sectional view of parts of a previously proposed semiconductor device;
Figure 5 is a sectional view illustrating another embodiment of the invention;
Figure 6 is a sectional view illustrating a further embodiment of the invention; and
Figure 7 illustrates an analogue integrated circuit including bipolar transistors and capacitive elements.

The embodiment to be described is a method of manufacturing a bipolar transistor integrated circuit.

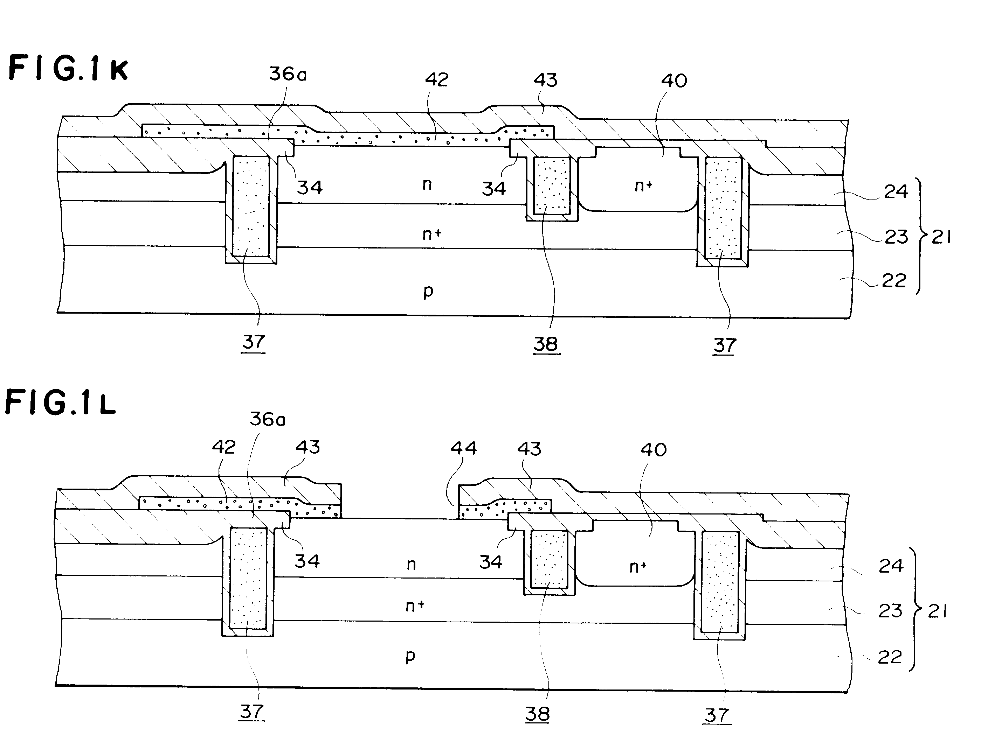

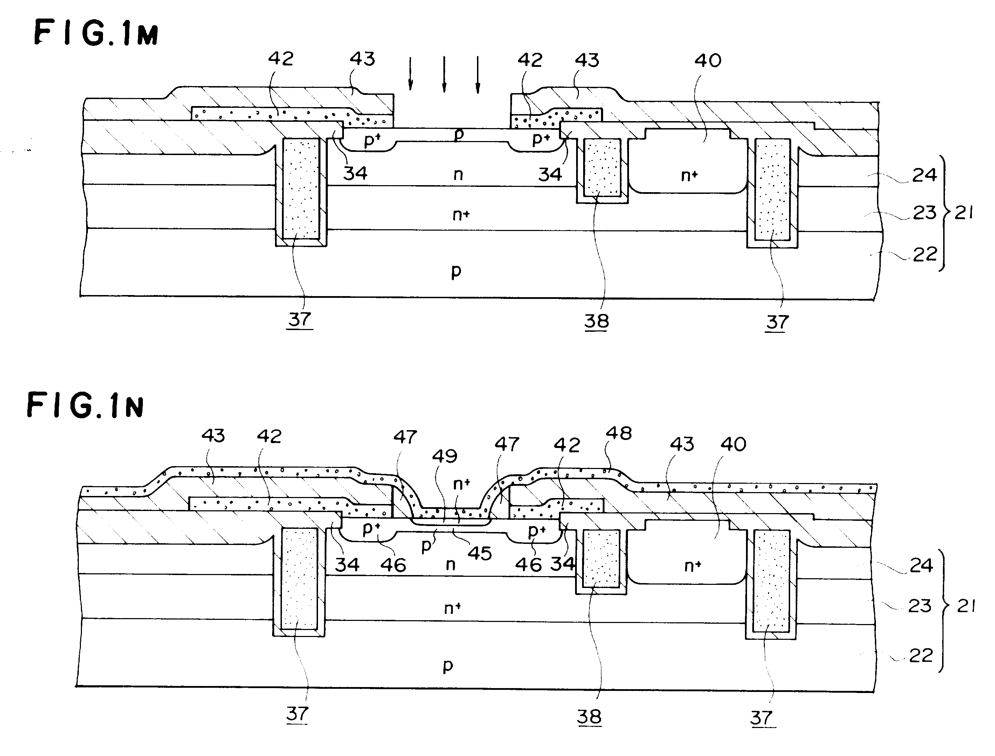

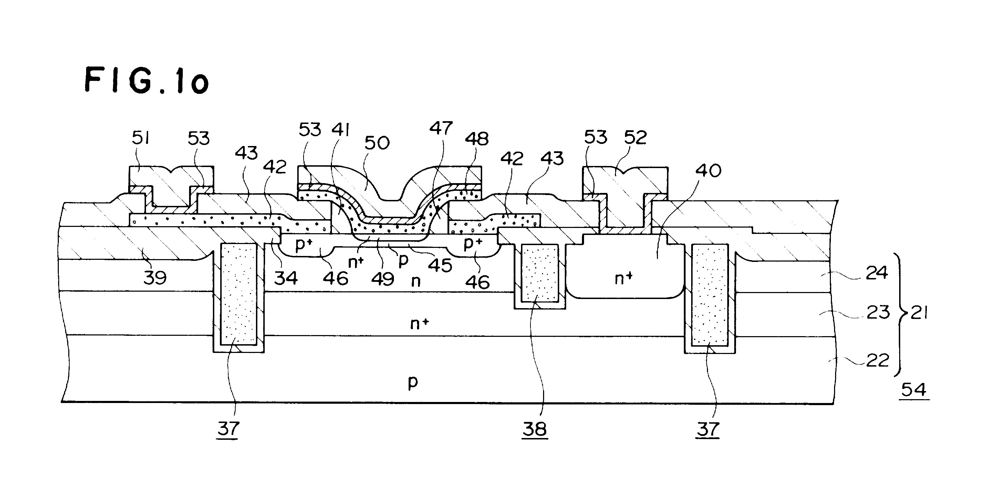

In this embodiment, as illustrated in Figure 1A, there are epitaxially deposited, on a p-type silicon semiconductor substrate 22, an n-type semiconductor layer 23 of a low resistivity to serve as a collector buried region, and then a semiconductor layer 24 of the same conductivity type as the semiconductor layer 23 but having a high resistivity to serve as a collector region, thereby constituting a semiconductor body 21. Subsequently the surface of the body 21 is thermally oxidized to form a thin buffer layer 25 comprising a silicon dioxide film, and there are further formed thereon a silicon nitride film 26 and a silicon dioxide film 27 to a thickness of 1 µm sequentially by, for instance, a chemical vapour deposition (CVD) process.

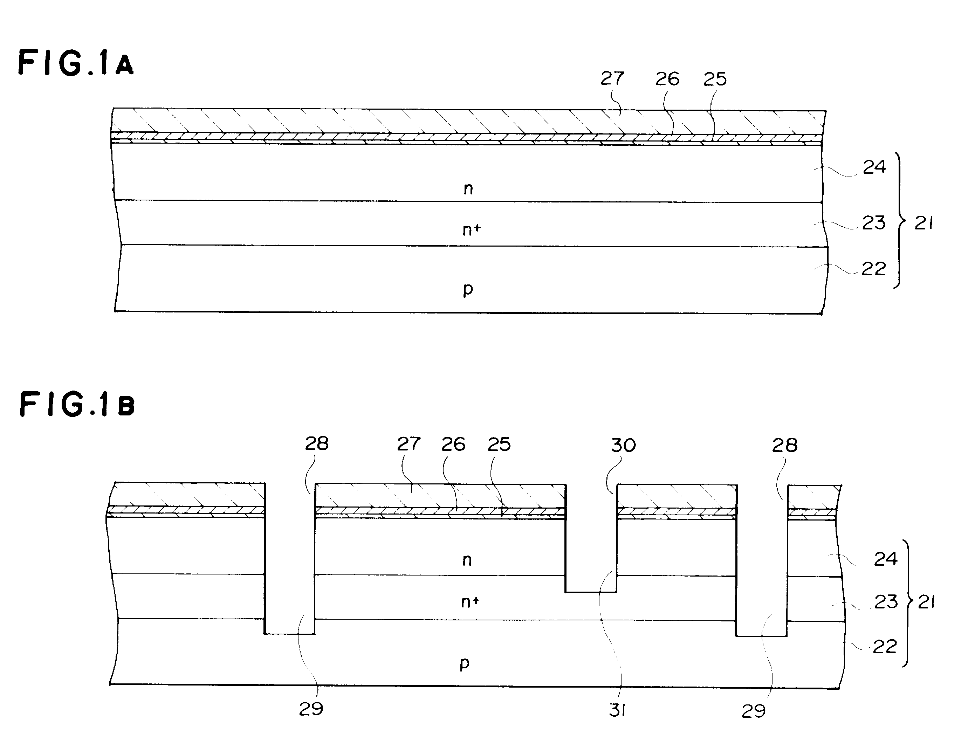

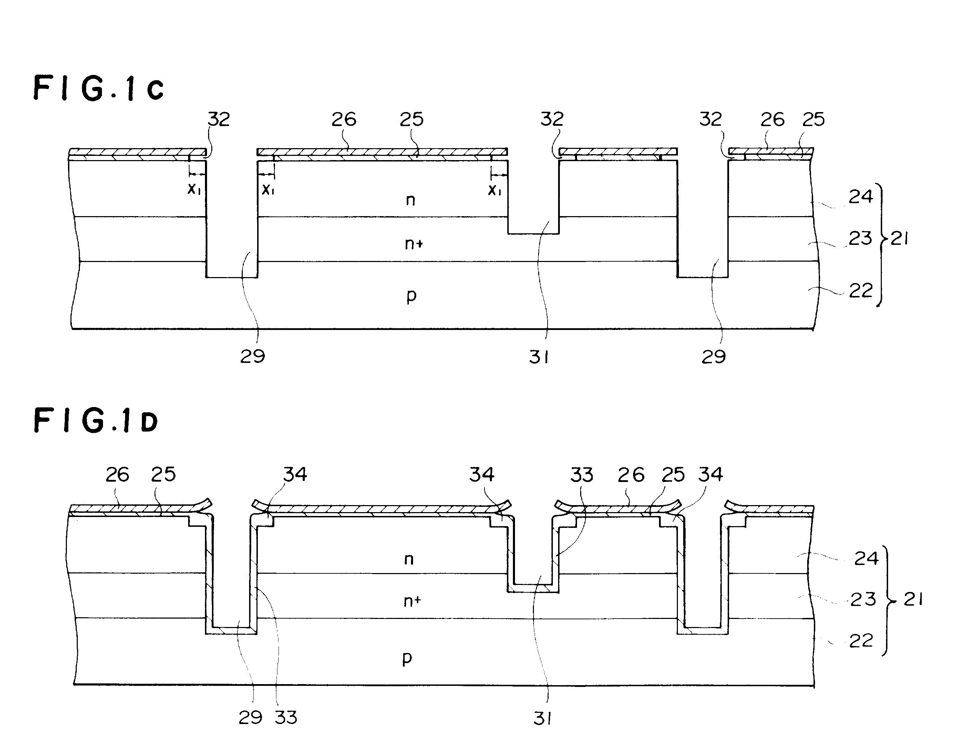

Thereafter, as illustrated in Figure 1B, windows 28 are formed to extend through the silicon dioxide film 27, the silicon nitride film 26 and the buffer layer 25 in portions where element isolating trenches are to be formed via a photoresist layer (not shown).

Then the body 21 is processed anisotropically by the technique of dry etching such as reactive ion etching (RIE) to a depth sufficient to transverse the semiconductor layers 24 and 23 through the windows 28 while the silicon dioxide film 27, the silicon nitride film 26 and the buffer layer 25 are used as masks, thereby forming element isolating trenches 29 (first trenches). Similarly, a window 30 is formed to extend through the silicon dioxide film 27, the silicon nitride film 26 and the buffer layer 25 in portions where the active region and the collector contact region of the transistor are to be mutually isolated, and dry etching such as RIE is executed through the window 30 to form a region isolating trench 31 (second trench) having a depth to reach the collector buried region 23.

In the next step, as illustrated in Figure 1C, the silicon dioxide film 27 is removed by etching, while the buffer layer 25 is also etched partially from its portions opposed to the inner surfaces of the trenches 29 and 31 in a manner so as to be undercut inwardly. The length x₁ of the undercut portion 32 can be determined as desired by the etching, and its optimum value ranges from 0.1 to 0.2µm.

Subsequently, as illustrated in Figure 1D, the inner wall surfaces of the first trenches 29 and second 31 are thermally oxidized with the silicon nitride film 26 used as a mask, thereby forming insulator layers 33 of silicon dioxide each having a thickness of 0.1 to 0.3µm. During such surface thermal oxidation, the semiconductor body surface opposed to the undercut portion 32 of the buffer layer 25 is oxidized simultaneously,, and some 'birds' beak' shapes are formed consequently to form insulator layer regions 34 of silicon dioxide each having a thickness of, for example 0.15 to 0.3µm which is greater than the thickness of the buffer layer 25.

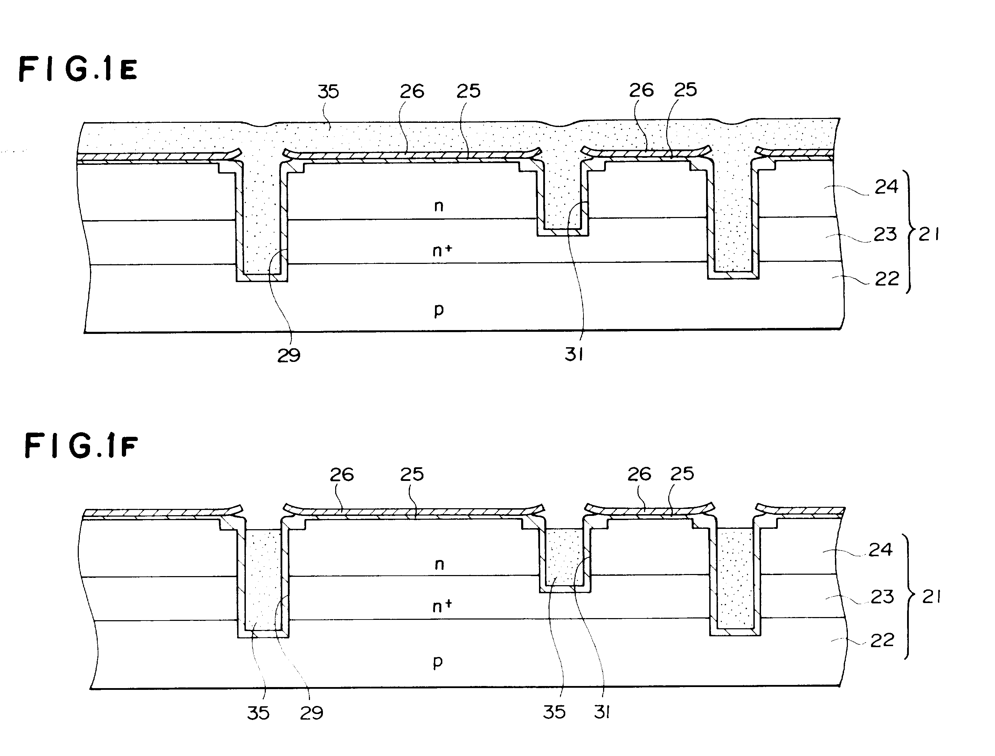

In the next step, as illustrated in Figure 1E, a semiconductor layer such as a polycrystalline silicon layer 35 is formed on the entire surface of the body 21 by, for instance, a CVD process , so that the trenches 29 and 31 are buried therein.

Next, as illustrated in Figure 1F, the polycrystalline silicon layer 35 is etched back in such a manner that its upper portion is removed anisotropically by, for instance, RIE down to the position of a predetermined depth from the body surface while being left unremoved in the element isolating trenches 29 and 31.

Subsequently, as illustrated in Figure 1G, the silicon nitride film 26 is removed, and then a silicon dioxide layer 36 is formed by, for instance, a CVD process on the body 21 inclusive of the trenches 29 and 31.

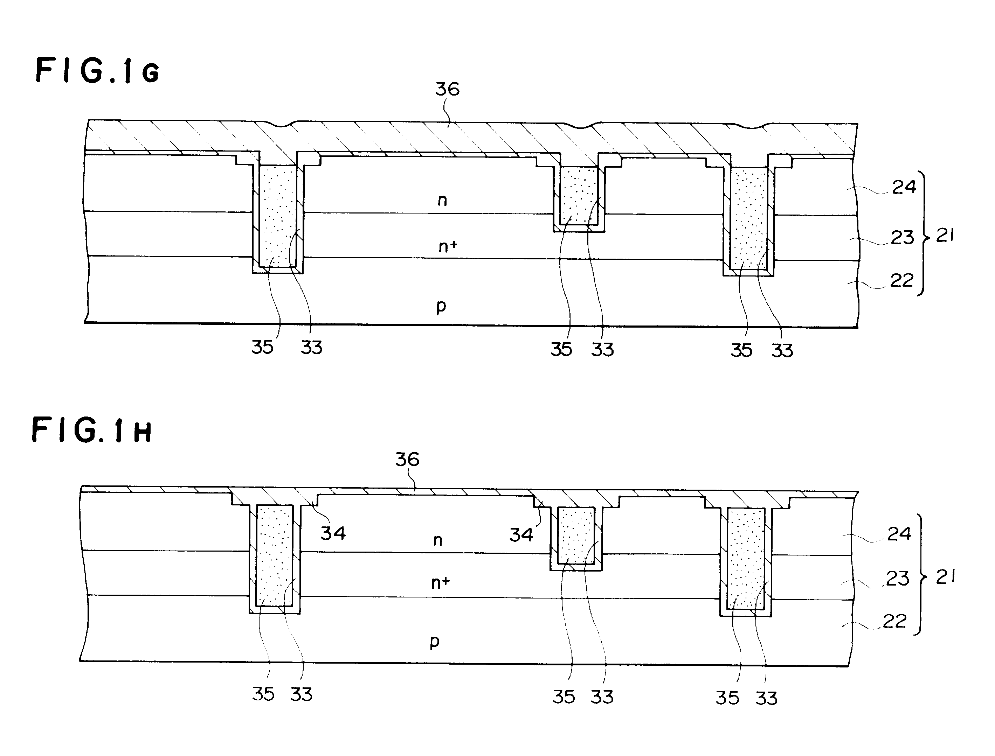

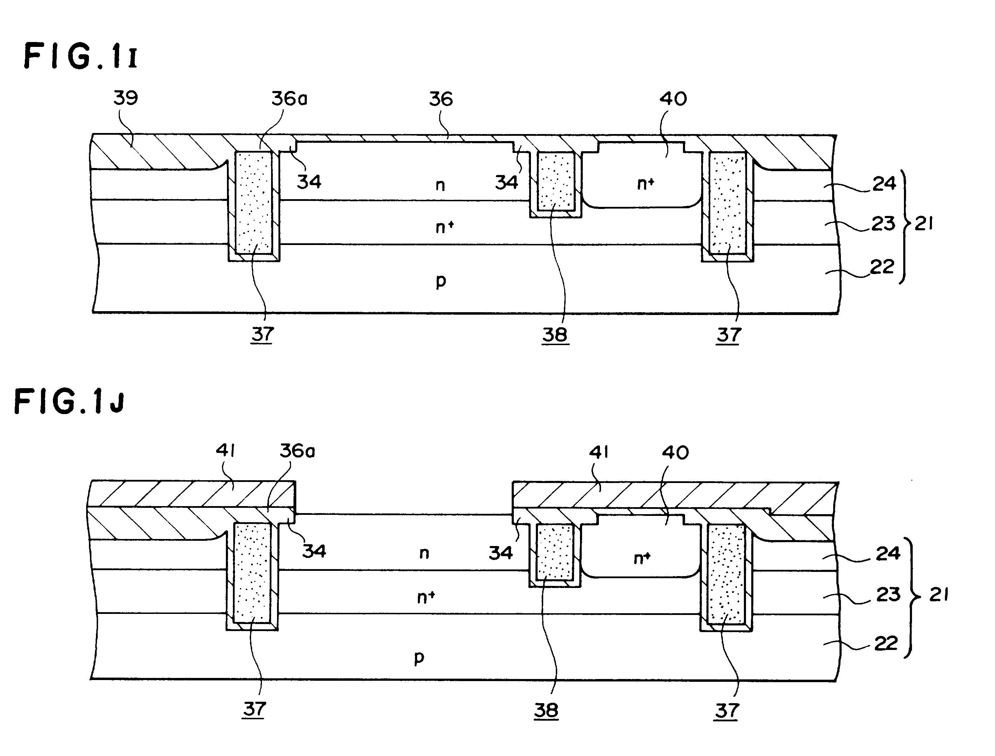

In the next step, as illustrated in Figure 1H, the silicon dioxide layer 36 is etched back by, for instance, an RIE process and is buried in the trenches 29 and 31, predetermined thickness of 0.1µm or so being left over the entire surface of the body 21, thereby forming element isolating regions 37 and an isolating region 38 as illustrated in Figure 1I. Next, a thick insulator layer 39 of silicon dioxide is formed in the field portion by selective oxidation (LOCOS). Subsequently an n-type impurity is introduced therein selectively by ion implantation to effect activation annealing, hence forming an n⁺ collector contact region 40.

Next, as illustrated in Figure 1J, a silicon dioxide layer 36a on the active region is selectively removed by etching via a photoresist layer 41. In this example, the removal of the silicon dioxide layer 36a on the active region is so performed as to leave the partial silicon dioxide layer 36a on the thick insulator layer region 34 adjacent to the upper edges of the isolating regions 37 and 38, thereby exposing the collector region 24 in the active region.

In the next step, as illustrated in Figure 1K, a polycrystalline silicon layer 42 doped with a p-type impurity such as boron (B) is deposited by, for instance, a CVD process on the entire surface and, except a portion covering the active region to be finally used as a base contact region and a lead for the base electrode, the remaining portions are selectively etched to be patterned. A silicon dioxide layer 43 to serve as a mask is formed by, for instance, a CVD process on the entire surface inclusive of the polycrystalline silicon layer 42.

Next, as illustrated in Figure 1L, the polycrystalline silicon layer 42 and the silicon dioxide layer 43 on the portion to form a base region are selectively removed by photoetching to form a window 44.

Next, as illustrated in Figure 1M, a p-type impurity such as boron is introduced by ion implantation through the window 44 and, simultaneously with execution of a heat treatment for activating the ion-implanted region to form a base region 45, the impurity from the polycrystalline silicon layer 42 is diffused to form a high-concentration base contact region 46 in the periphery of the base region 45.

In the next step, as illustrated in Figure 1N, a silicon dioxide layer is deposited on the entire surface by, for instance, a CVD process, and then anisotropic etching such as RIE is applied to form a side wall 47 of silicon dioxide on the inner surface of the window 44. Subsequently, a polycrystalline silicon layer 48 doped with an n-type impurity such as arsenic is deposited on the entire surface inclusive of the base region 45 opposite to the side wall 47 of silicon dioxide and, by a heat treatment, the impurity from the polycrystalline silicon layer 48 is diffused to form an emitter region 49.

Thereafter, as illustrated in Figure 10, an emitter electrode 50 is formed on the patterned polycrystalline silicon layer 48, and a base electrode 51 is formed adjacent to the end of the polycrystalline silicon layer 42 used as a lead. Furthermore, a collector electrode 52 is formed adjacent to the collector contact region 40. The electrodes 50, 51 and 52 are composed of aluminium for example. When necessary, a barrier metal 53 may be interposed between the electrode and the silicon. Thus a desired bipolar transistor integrated circuit 54 is produced.

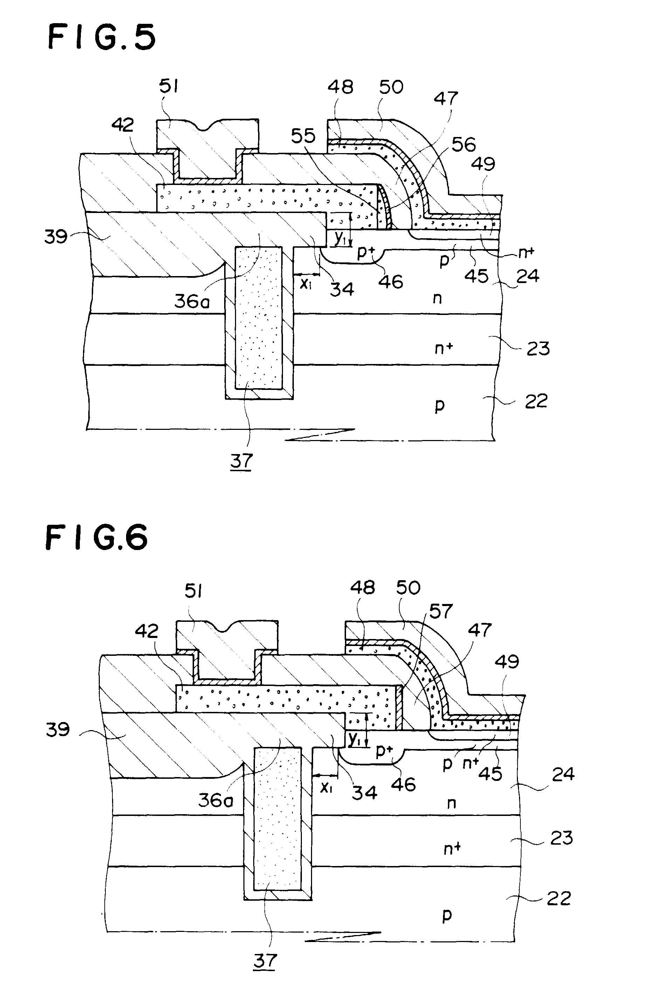

The following steps may also be executed, as illustrated in Figure 5, after the step shown in Figure 1L. That is, on the entire surface including the window 44, a second semiconductor layer of polycrystalline silicon can be formed by, for instance, a CVD process to serve as a portion of the base electrode.

Then this second semiconductor layer is processed anisotropically by, for example, RIE so as to be etched back, so that the semiconductor layer formed thickly in the etching direction is left as a first side wall 55 on the lateral surface of the window. Thus, a base electrode is constituted of the first side wall 55 and the remaining portion of the first semiconductor layer 42 adjacent thereto.

Next the surface of the first side wall 55 composed of the second semiconductor layer is thermally oxidized to form an oxide film 56.

Furthermore an insulator layer of, for example silicon dioxide is deposited by, for instance, a CVD process on the entire surface inclusive of the window 44 and the first side wall 55 which has the oxide film 56 on its surface.

Subsequently the insulator layer is anisotropically etched by, for instance, RIE to form a second side wall 47 on the first side wall 55 via the oxide film 56.

The above represents an exemplary case of applying the present invention to a bipolar transistor where a graft base region 46 is selectively formed under the first side wall 55 which partially constitutes the base electrode. However, where the structure is such that the base electrode is composed merely of the first semiconductor layer 42 alone without any side wall, as shown in Figure 6, it is possible to form an oxide film 57 by thermally oxidizing the emitter-side end surface of the semiconductor layer 42 constituting the base electrode.

With the structure described, an oxide film 56, 57 is formed between the base electrode 51 and the emitter electrode 50 by thermally oxidizing at least the semiconductor layer itself of the base electrode 51. Therefore, due to the step of thermal oxidation, even when the insulator layer formed thereon is leaky, the fine oxide film formed by oxidizing the second semiconductor layer therethrough can consequently enhance the dielectric strength between the emitter and the base, as well as prevent generation of any leakage current with certainty.

Thus, it becomes possible to realize an improved bipolar transistor having high operational reliability.

In the embodiment described above, the element isolating region 37 and the isolating region 38 are formed by burying the polycrystalline silicon layer 35 and the silicon dioxide layer 36 in the trenches 29 and 31. However, the structure may be so modified as to bury solely silicon dioxide in the entirety of the trenches 29 and 31.

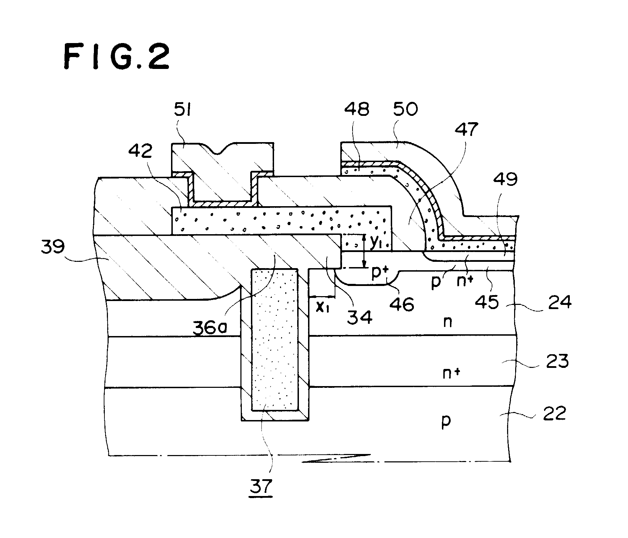

With such a modified structure, merely the undercut portions formed along the inner walls of the trenches 29 and 31 and the upper edges thereof are selectively oxidized so that thick insulator layer regions 34 of silicon dioxide are formed in a manner to be buried in the surface portion of the body 21 adjacent to the upper edges of the trenches 29 and 31. Consequently, due to the insulator layer regions 34 and the silicon dioxide layer 36a formed thereon as shown in the enlarged view of Figure 2, the substantial insulator layer between the polycrystalline silicon layer 42 used as a lead for the base electrode 51 and the n-type semiconductor layer 24 serving as a collector region has a great thickness y1 which ranges from 0.25 to 0.4µm, thereby reducing the parasitic MIS capacitance C₂. Furthermore, because of the undercut and so forth, the tolerance dimension between the isolating region 37 and the base contact region 46 can be determined by self-alignment, whereby the length x₁ can easily be reduced to a range of 0.1 to 0.2µm, hence reducing the parasitic MIS capacitance C₂ by an amount corresponding to such dimensional diminution. As a result, the capacitance C_{CB} between the base and the collector can be decreased, consequently to realize a superfast bipolar transistor integrated circuit.

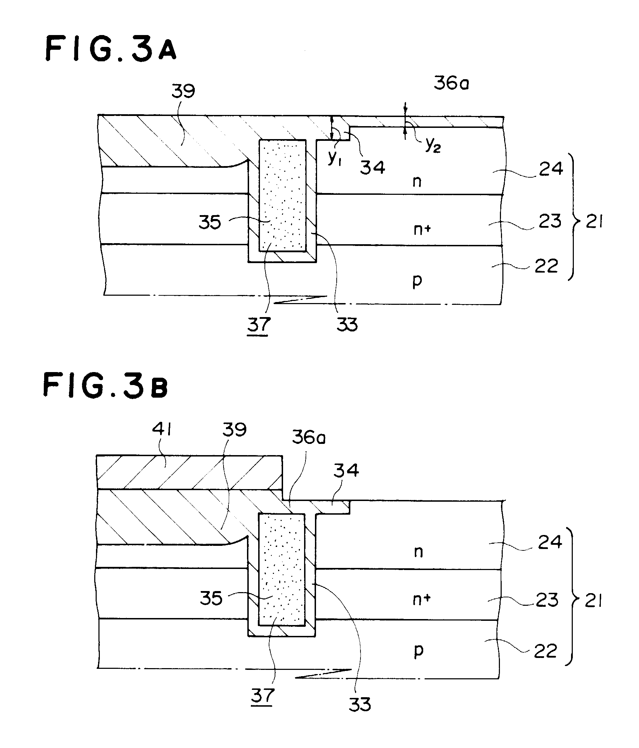

Figure 3A to 3C show another embodiment of the present invention. In this example, after the aforementioned step of Figure 1I or after the element isolating region 37 and the isolating region 38 (not shown) are formed as illustrated in Figure 3A, the silicon dioxide layer 36a is etched with self-alignment via the photoresist layer 41, as illustrated in Figure 3B, by utilizing the difference between the thickness y1 of the insulator layer proximate to the isolating regions 37 and 38, and the thickness y2 of the silicon dioxide layer 36a on the body surface spaced apart from the isolating regions 37 and 38, thereby exposing the body surface on the active region. Thereafter the same steps as those after Figure 1K are executed to produce a bipolar transistor integrated circuit 58 shown in Figure 3C.

Also in this bipolar transistor integrated circuit 54 due to the existence of the insulator layer region 34 adjacent to the upper edges of the isolating regions 37 and 38, the insulator layer between the polycrystalline silicon layer 42 used as a lead for the base electrode 51 and the n-type semiconductor layer 24 serving as a collector region can be formed to have a sufficient thickness y3 of 0.3µm or so, which is greater than the known value, and the tolerance dimension x₁ between the isolating regions 37 and 38 and the base contact regions 46 can be diminished eventually to reduce the parasitic MIS capacitance C₂ also, hence decreasing the base-to-collector capacitance C_{CB} as well, consequently to provide an enhanced bipolar transistor integrated circuit for superfast operation.

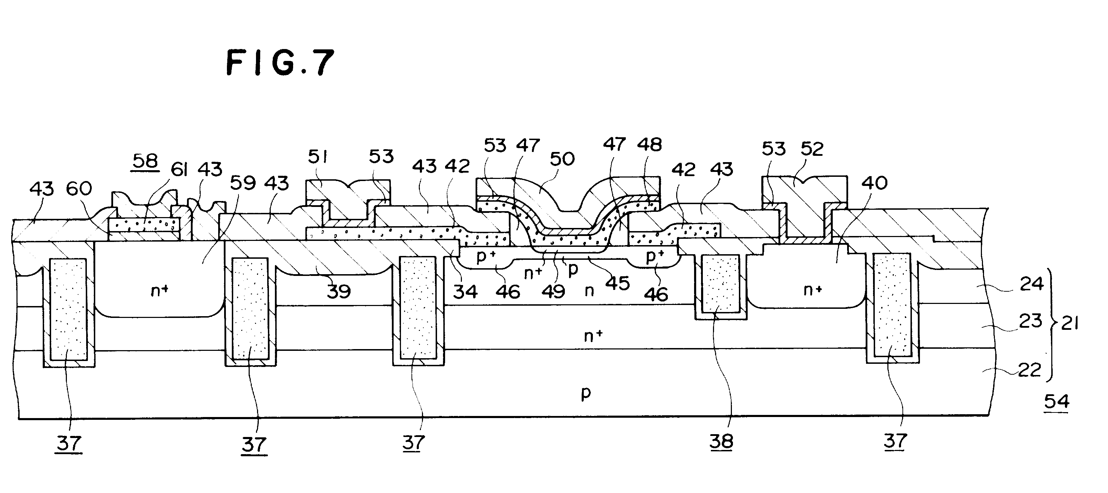

In an analogue integrated circuit of bipolar transistors, it is generally necessary to form capacitive elements together with bipolar transistors. An example of such an analogue integrated circuit produced according to an embodiment of the present invention with bipolar transistors and capacitive elements is illustrated in Figure 7, wherein both bipolar transistors 54 and capacitive elements 58 are arranged on a common semiconductor body 21. In the bipolar transistor 54, its base electrode 51 and emitter electrode 50 comprise first and second low-resistivity semiconductor layers 42 and 48 respectively. Meanwhile the capacitive element 58 has a MIS structure wherein a low-resistivity impurity region 59 formed on the body 21 is used as one electrode, and a low-resistivity semiconductor layer 61 is deposited thereon at least as a foundation layer for another electrode via an insulator film 60 or a dielectric film.

In manufacturing the capacitive element 58 of the MIS structure, its low-resistivity impurity region 59 is formed simultaneously with the low-resistivity collector contact region 40 for the collector electrode of the bipolar transistor 54, and the low-resistivity semiconductor layer 61 is composed of the first or second semiconductor layer 42 or 48 which partially constitutes the bipolar transistor 54.

In the capacitive element 58 of the MIS structure where the low-resistivity impurity region 59 serving as one electrode is composed of the region of a sufficiently high concentration formed simultaneously with the collector contact region 40 for the collector electrode of the bipolar transistor 54, its sheet resistivity becomes, for example, 10 ohms per square centimetre, so that the distributed resistance therein can be considerably reduced consequently to obtain a satisfactory capacitive element 58 of excellent characteristics having a high Q value. Furthermore, since there is no dielectric insulator layer on the metal layer of, for instance, aluminium, a high-reliability insulator film 60 to serve as a dielectric layer can be composed of a sufficiently thin silicon nitride film having a thickness of 5 x 10⁻⁸m or so. Therefore, in forming the silicon nitride film particularly by low-pressure chemical vapour deposition (LP-CVD) or a vapour phase growth process, it becomes possible to ensure a remarkably fine film with accuracy, hence attaining an increase of the capacitance per area with enhanced stability. Thus, it is possible to achieve a greater integration density and a resultant faster operation, thereby realizing a semiconductor device of high reliability and enhanced stability, such as an analogue integrated circuit of bipolar transistors.

Furthermore, since there is no layer of, for instance, aluminium under the dielectric insulator layer 60 of the capacitive element 58 of the MIS structure, there is no necessity of a great film thickness which may otherwise be required to compensate for the surface roughness with hillocks and so forth, and therefore the insulator film may be formed sufficiently thin (5 x 10⁻⁸m or so), hence increasing the capacitance per area and attaining high reliability due to its flatness.

Besides the above, as the device is so constituted that the low-resistivity semiconductor layer 61 is deposited on the insulator film 60, it is possible to protect the insulator film 60 in the step of forming a window in the silicon dioxide layer 43 or when executing anisotropic dry etching or RIE to pattern the second low-resistivity semiconductor layer 61, thereby enhancing the stability and quality of the dielectric insulator film 60 eventually to constitute a satisfactory capacitive element 58 of remarkably high reliability with great advantages in practical use.

Thus, in the embodiments of the invention, wherein trench-shaped isolating regions are formed in a semiconductor body and a wiring layer extends on each isolating region and is connected to an impurity region on the semiconductor body, an insulator layer region is buried in the surface portion of the semiconductor body under the wiring layer and adjacent to the isolating region, whereby the insulation space between the wiring layer and the semiconductor body surface can be increased while the distance between the isolating region and the impurity region can be shortened. As a result, the parasitic capacitance between the wiring layer and the semiconductor body can be diminished to attain a faster operation in the semiconductor device. Particularly, the capacitance C_{CB} between the base and collector of a bipolar transistor integrated circuit can be reduced consequently to realize superfast operation.

## Claims

1. A method of making a bipolar transistor integrated circuit comprising a bipolar transistor having an active region and isolating trenches, the method comprising the steps of:
providing a semiconductor body (21) having a surface and a semiconductor layer (24) of a first conductivity type adjoining said surface;
oxidizing the surface of the body (21) thereby forming a thin buffer layer (25);
forming thereon an oxidation resistant film (26) and a silicon dioxide film (27);
forming windows (28,30) extending through said silicon dioxide film (27), said oxidation resistant film (26) and said buffer layer (25) in portions where said isolating trenches are to be formed;
etching the semiconductor body (21) through said windows (28,30) while the silicon dioxide film (27), the oxidation resistant film (26) and the buffer layer (25) are used as masks, thereby forming isolating trenches (29,31) having inner walls and upper edges;
removing said silicon dioxide film (27) by etching, while portions of said buffer layer (25) adjacent to said isolating trenches (29,31) are also etched under the oxidation resistant film (27) thereby forming undercut portions (32) along the inner walls of said isolating trenches (29,31) and the upper edges thereof;
thermally oxidizing the inner wall surfaces of said isolating trenches (29,31) with said oxidation resistant film (26) used as a mask, thereby forming insulator layers (33), the semiconductor body surface opposed to said undercut portions (32) of the buffer layer (25) being oxidized simultaneously during the thermal oxidation, thereby forming an insulator region (34) buried in the surface portion of said semiconductor body (21) adjacent to the upper edges of said isolating trenches;
removing said oxidation resistant film (26);
forming a silicon dioxide layer (36) on the semiconductor body (21) inclusive of said isolating trenches (29,31);
etching back said silicon dioxide layer (36), a thickness being left over said surface of the semiconductor body (21), said silicon dioxide layer (36) being buried in said isolating trenches (29,31) thereby forming isolating regions (37,38);
removing the portion (36a) of said silicon dioxide layer (36) located on said active region of the bipolar transistor;
depositing a semiconductor conductive layer (42) doped with an impurity of a second conductivity type on the entire surface and selectively etching said semiconductor conductive layer (42) except for a portion covering said active region of the bipolar transistor;
forming a further silicon dioxide layer (43) on the entire surface;
selectively removing said semiconductor conductive layer (42) and said further silicon dioxide layer (43) by etching, whereby a window (44) is defined within said active region where a base region is to be formed, said semiconductor conductive layer (42) being left extending outside said window (44);
introducing an impurity of said second conductivity type through said window (44) to form a base region (45), and diffusing said impurity of said second conductivity type from said semiconductor conductive layer (42) into the periphery of the base region (45) to form a base contact region (46);
forming a side wall (47) of silicon dioxide on the inner surface of said window (44);
depositing a polycrystalline silicon layer (48) doped with an impurity of said first conductivity type on the base region (45), and diffusing the impurity from said polycrystalline silicon layer (48), whereby an emitter region (49) is formed in the base region (45);
forming an emitter electrode (50) on said polycrystalline silicon layer (48) and a base electrode (51) on said semiconductor conductive layer (42).

2. A method of making a bipolar transistor integrated circuit as claimed in claim 1, further comprising, after the step of forming the window (44) and prior to the step of forming a side wall (47) of silicon dioxide, the step of oxidizing the side end surface of the semiconductor conductive layer (42) on the inner surface of said window (44), thereby forming an oxide film (57)

## Patentansprüche

1. Verfahren zur Herstellung einer integrierten Bipolartransistorschaltung, die einen Bipolartransistor mit einem aktiven Bereich und Isolationsgräben umfaßt,
wobei das Verfahren die Schritte umfaßt:
Bereitstellen eines Halbleiterkörpers (21) mit einer Oberfläche und einer angrenzend zu der Oberfläche ausgebildeten Halbleiterschicht (24) eines ersten Leitfähigkeitstyps,
Oxidieren der Oberfläche des Körpers (21), wodurch eine dünne Pufferschicht (25) ausgebildet wird,
Ausbilden einer gegenüber Oxidation widerstandsfähigen Schicht (26) und einer Siliziumdioxidschicht (27) darauf,
Ausbilden von Fenstern (28, 30), die durch die Siliziumdioxidschicht (27), die gegenüber Oxidation widerstandsfähigen Schicht (26) und die Pufferschicht (25) an Stellen verlaufen, wo die Isolationsgräben ausgebildet werden sollen,
Ätzen des Halbleiterkörpers (21) durch die Fenster (28, 30), wobei die Siliziumdioxidschicht (27), die gegenüber Oxidation widerstandsfähige Schicht (26) und die Pufferschicht (25) als Masken verwendet werden, so daß Isolationsgräben (29, 31) mit Innenwänden und Oberkanten ausgebildet werden,
Entfernen der Siliziumdioxidschicht (27) durch Ätzen, wobei auch benachbart zu den Isolationsgräben (29, 31) angeordnete Abschnitte der Pufferschicht (25) unterhalb der gegenüber Oxidation widerstandsfähigen Schicht (27) geätzt werden, so daß entlang der Innenwände und der Oberkanten der Isolationsgräben (29, 31) unterschnittene Abschnitte (32) ausgebildet werden,
Durchführen einer Wärmeoxidation der Oberflächen der Innenwände der Isolationsgräben (29, 31), wobei die gegenüber Oxidation widerstandsfähige Schicht (26) als Maske verwendet wird, so daß Isolationsschichten (33) ausgebildet werden, wobei gleichzeitig die gegenüberliegend zu den unterschnittenen Abschnitten (32) der Pufferschicht (25) angeordnete Halbleiterkörperoberfläche während der Wärmeoxidation oxidiert wird, so daß ein Isolationsbereich (34) ausgebildet wird, der in dem benachbart zu den Oberkanten der Isolationsgräben angeordneten Oberflächenabschnitt des Halbleiterkörpers (21) eingebettet ist,
Entfernen der gegenüber Oxidation widerstandsfähigen Schicht (26),
Ausbilden einer Siliziumdioxidschicht (36) auf dem Halbleiterkörper (21) einschließlich der Isolationsgräben (29, 31),
Ätzen der Siliziumdioxidschicht (36), wobei eine gewisse Dicke auf der Oberfläche des Halbleiterkörpers (21) zurückbleibt und die Siliziumdioxidschicht (36) in den Isolationsgräben (29, 31) eingebettet ist, so daß Isolationsbereiche (37, 38) ausgebildet werden,
Entfernen des auf dem aktiven Bereich des Bipolartransistors angeordneten Abschnitts (36a) der Siliziumdioxidschicht (36),
Aufbringen einer mit Störstellen eines zweiten Leitfähigkeitstyps dotierten Halbleiterschicht (42) auf die gesamte Oberfläche und selektives Ätzen der Halbleiterschicht (42) mit Ausnahme eines Abschnitts, der den aktiven Bereich des Bipolartransistors bedeckt,
Ausbilden einer weiteren Siliziumdioxidschicht (43) auf der gesamten Oberfläche, selektives Entfernen der Halbleiterschicht (42) und der weiteren Siliziumdioxidschicht (43) durch Ätzen, wodurch ein Fenster (44) innerhalb des aktiven Bereichs an einer Stelle definiert wird, wo ein Basisbereich ausgebildet werden soll, wobei die Halbleiterschicht (42) außerhalb des Fensters (44) beibehalten wird,
Einführen von Störstellen des zweiten Leitfähigkeitstyps durch das Fenster (44), um einen Basisbereich (45) auszubilden, und Eindiffundieren der Störstellen des zweiten Leitfähigkeitstyps von der Halbleiterschicht (42) in die Peripherie des Basisbereichs (45), um einen Basiskontaktbereich (46) auszubilden,
Ausbilden einer Seitenwand (47) aus Siliziumdioxid auf der Innenfläche des Fensters (44),
Aufbringen einer mit Störstellen des ersten Leitfähigkeitstyps dotierten polykristallinen Schicht (48) auf den Basisbereich (45) und Eindiffundieren der Störstellen von der polykristallinen Siliziumschicht (48) aus, wodurch ein Emitterbereich (49) in dem Basisbereich (45) ausgebildet wird,
Ausbilden einer Emitterelektrode (50) auf der polykristallinen Siliziumschicht (48) sowie einer Basiselektrode (51) auf der Halbleiterschicht (42).

2. Verfahren zur Herstellung einer integrierten Bipolartransistorschaltung nach Anspruch 1, weiterhin umfassend, nach dem Schritt der Ausbildung des Fensters (44) und vor dem Schritt der Ausbildung einer Seitenwand (47) aus Siliziumdioxid, den Schritt Oxidieren der seitlichen Endfläche der Halbleiterschicht (42) auf der Innenfläche des Fensters (44), wodurch eine Oxidschicht (57) ausgebildet wird.

## Revendications

1. Procédé de fabrication d'un circuit intégré à transistors bipolaires comprenant un transistor bipolaire ayant une zone active et des tranchées d'isolation, le procédé comprenant les étapes de :
fourniture d'un corps semi-conducteur (21) ayant une surface et une couche semi-conductrice (24) d'un premier type de conductivité avoisinant ladite surface ;
oxydation de la surface du corps (21) formant ainsi une couche tampon mince (25) ;
formation sur celle-ci d'un film résistant d'oxydation (26) et d'un film de dioxyde de silicium (27) ;
formation de fenêtres (28, 29) s'étendant à travers ledit film de dioxyde de silicium (27), ledit film résistant d'oxydation (26) et ladite couche tampon (25) dans des parties où lesdites tranchées d'isolation sont à former ;
gravure du corps semi-conducteur (21) à travers lesdites fenêtres (28, 30) alors que le film de dioxyde de silicium (27), le film résistant d'oxydation (26) et la couche tampon (25) sont utilisés comme masques, formant ainsi des tranchées d'isolation (29, 31) ayant des parois internes et des bords supérieurs ;
enlèvement dudit film de dioxyde de silicium (27) par gravure, alors que des parties de ladite couche tampon (25) adjacente auxdites tranchées d'isolation (29, 31) sont aussi gravées sous le film résistant d'oxydation (27) formant ainsi des parties sous-découpées (32) le long des parois internes desdites tranchées d'isolation (29, 31) et les bords supérieurs de celles-ci ;
oxydation thermique des surfaces de paroi interne desdites tranchées d'isolation (29, 31) avec ledit film résistant d'oxydation (26) utilisé comme masque, formant ainsi des couches d'isolation (33), la surface du corps semi-conducteur opposé auxdites parties sous-découpées (32) de la couche tampon (25) étant oxydée simultanément pendant l'oxydation thermique, formant ainsi une zone d'isolation (34) enterrée dans la partie de surface dudit corps semi-conducteur (21) adjacent aux bords supérieurs desdites tranchées d'isolation ;
enlèvement dudit film résistant d'oxydation (26) ;
formation d'une couche de dioxyde de silicium (36) sur le corps semi-conducteur (21) comprenant lesdites tranchées d'isolation (29, 31) ;
gravure arrière de ladite couche de dioxyde de silicium (36), une épaisseur étant laissée sur ladite surface du corps semi-conducteur (21), ladite couche de dioxyde de silicium (36) étant enterrée dans lesdites tranchées d'isolation (29, 31) formant ainsi des zones d'isolation (37, 38) ;
enlèvement de la partie (36a) de ladite couche de dioxyde de silicium (36) située sur ladite zone active du transistor bipolaire ;
dépôt d'une couche conductrice de semi-conducteur (42) dopée avec une impureté d'un second type de conductivité sur la surface entière et gravure sélectivement de ladite couche conductrice de semi-conducteur (42) sauf pour la partie couvrant ladite zone active du transistor bipolaire ;
formation d'une autre couche de dioxyde de silicium (43) sur la surface entière ;
enlèvement sélectif de ladite couche conductrice de semi-conducteur (42) et de ladite autre couche de dioxyde de silicium (43) par gravure, de sorte qu'une fenêtre (44) est définie dans ladite zone active où une zone de base est à former, ladite couche conductrice de semi-conducteur (42) étant laissée s'étendant en dehors de ladite fenêtre (44) ;
introduction d'une impureté dudit second type de conductivité à travers ladite fenêtre (44) pour former une zone de base (45), et diffusion de ladite impureté dudit second type de conductivité à partir de ladite couche conductrice de semi-conducteur (42) dans le pourtour de la zone de base (45) pour former une zone de contact de base (46) ;
formation d'une paroi latérale (47) de dioxyde de silicium sur la surface interne de ladite fenêtre (44) ;
dépôt d'une couche de silicium polycristallin (48) dopée avec une impureté dudit premier type de conductivité sur la zone de base (45), et diffusion de l'impureté à partir de ladite couche de silicium polycritallin (48), de sorte qu'une zone d'émetteur (49) est formée dans la zone de base (45) ;
formation d'une électrode d'émetteur (50) sur ladite couche de silicium polycristallin (48) et électrode de base (51) sur ladite couche conductrice semi-conducteur (42).

2. Procédé de fabrication d'un circuit intégré à transistor bipolaire selon la revendication 1,
comprenant en outre, après l'étape de formation de la fenêtre (44) et avant l'étape de formation d'une paroi latérale (47) de dioxyde de silicium, l'étape d'oxydation de la surface d'extrémité latérale de la couche conductrice de semi-conducteur (42) sur la surface interne de ladite fenêtre (44), formant ainsi une couche d'oxyde (57).
